# EUROPÄISCHE PATENTSCHRIFT

(11) **EP 3 045 429 B1**
(45) Veröffentlichungstag und Bekanntmachung des Hinweises auf die Patenterteilung: **03.06.2020**
(21) Anmeldenummer: 16000105.3
(22) Anmeldetag: 17.01.2016
(51) Int. Cl.: C02F 1/28, C02F 101/10, C02F 103/00, C02F 103/42, B01J 20/06

(54) **VERFAHREN ZUR BINDUNG VON GELÖSTEM PHOSHOR IN TEICHEN, SCHWIMMBECKEN, BIOPOOLS UND AQUARIEN**
METHOD FOR THE ADSORPTION OF DISSOLVED PHOSPHOROUS IN PONDS, SWIMMING POOLS, BIOPOOLS AND AQUARIUMS
PROCÉDÉ D'ADSORPTION DE PHOSPHORE DISSOUS DANS LES MARES, PISCINES, BIOPISCINES ET AQUARIUMS

(30) Priorität: 19.01.2015 DE 102015000349
(43) Veröffentlichungstag der Anmeldung: 20.07.2016
(73) Patentinhaber: MINNOVA BNS GmbH, 06279 Alberstedt (DE)
(72) Erfinder: Siegert, Horst, 06279 Farnstädt/OT Alberstedt (DE)
(74) Vertreter: Beyer, Wolfgang

(56) Entgegenhaltungen:
- WO-A1-95/13246
- WO-A1-2009/103103
- WO-A1-2014/017500
- US-A1- 2013 098 840
- Arto Latvala: "MULTILAYER INTERMITTENT SAND FILTER", , 1. Januar 1993 (1993-01-01), Seiten 125-132, XP055259820, Gefunden im Internet: URL:http://wst.iwaponline.com/content/ppiw awst/28/10/125.full.pdf [gefunden am 2016-03-18]

## Beschreibung

Die Erfindung betrifft ein Verfahren zur Bindung von gelöstem Phosphor, insbesondere in biologischen Schwimmbädern und Teichen. Darüber hinaus soll die erfindungsgemäße Lösung auch in Aquarien oder für Wasserspiele wie beispielsweise mit Quellsteinen angewendet werden können.

In Wasser gelöstes Phosphor ist die Hauptursache für Algenwachstum und sich bildende Belege. Bei den in biologischen Schwimmbädern und Teichen ablaufenden komplexen Prozessen werden ständig Nährstoffe aufgenommen und wieder freigesetzt. Infolge äußerer Einflüsse wie Badeaktivitäten oder jahreszeitlich bedingte Einflüsse kann es zu temporären Anreicherungen von gelöstem Phosphor im Wasser kommen. Dabei werden von den vorhandenen Algen oder Biofilmen derartige Überangebote an Phosphor schneller genutzt, als diese durch biologische Filtration wieder gebunden werden können. Um Phosphate aus wässrigen Lösungen selektiv zu entfernen, sind Verfahren geschaffen worden, bei denen die wässrige Lösung mit einem wasserunlöslichen phosphatadsorbierenden Mittel in Kontakt gebracht wird. So wird nach der DE 25 26 053 C2 ein Verfahren zur selektiven Entfernung von Phosphor beschrieben, bei dem eine Verbindung eingesetzt wird, die aus einem mehrwertigen Metallion und einem organischen Liganden besteht. Der Ligand enthält dabei zur Chelatkomplexbildung geeignete saure Gruppen. Durch den Einsatz dieser chemischen Verbindung wurde ein Behandlungsmittel führt die wässrige Lösung geschaffen, das eine gegenüber bisheriger Lösungen höhere Kapazität und leichtere Regenerierbarkeit aufweist. Nachteilig an diesem Verfahren ist jedoch die fehlende Eignung der teilweise aggressiven chemischen Verbindungen für die Anwendung in biologischen Schwimmbädern und Teichen. Zudem kommen die chemischen Verbindungen im Zusammenhang mit Fällungsvorgängen zur Anwendung. Bekannt ist auch ein Mittel und eine Vorrichtung zur biologischen und/oder biochemischen Wasseraufbereitung nach der DE 20 2004 013 885 U1. Nach dieser Lösung kommen ökologisch unbedenkliche und weitgehend naturbelassene Mittel zur Aufbereitung und Qualitätsverbesserung von Wasser in Teichen, Seen usw. zur Anwendung. Dazu besteht das Mittel im wesentlichen aus Inhaltsstoffen und/oder Wirkstoffen und/oder Mikroorganismen mit Reinigungswirkung und/oder Bakterien und/oder Pilzen und/oder Hefen und/oder Mineralstoffen und/oder Vitaminen und/oder Enzymen. Mit dieser Lösung wird das Wachstum von Faden- und Schleimalgen eingedämmt und bei der Anwendung insbesondere in Gartenteichen wird gleichzeitig die Herstellung von klarem Wasser auf biologischem und/oder die chemischen Wege ermöglicht. Nachteilig ist auch an dieser Lösung der hohe Aufwand für die Bereitstellung der Mittel sowie die fehlende Möglichkeit der gesteuerten Einflussnahme auf das Gleichgewicht des komplexen Ablaufes zwischen Biofiltern und pflanzenverfügbarem Phosphor. US 2013/098840 betrifft ein Verfahren zum Binden von Phosphor mittels eines Filtrationsmediums, das Eisenhydroxid oder Lanthan und Bestandteile auf Eisenbasis umfasst. Die Aufgabe der Erfindung besteht deshalb in der Schaffung eines Verfahrens, mit dem die Bindung des gelösten Phosphors ermöglicht und die Steuerung des Gleichgewichts zwischen Biofilter und pflanzenverfügbaren Phosphor durchgeführt werden kann. Gelöst wird diese Aufgabe mit dem Verfahren nach den beschreibenden Merkmalen der Patentansprüche 1 bis 6. Bei der vorliegenden Lösung kommt als chemische Verbindung für die Bindung von gelöstem Phosphor eine Verbindung von Eisenhydroxid und Lanthan zur Anwendung. Mit dem bisher bekannten für die Phosphorbindung zur Anwendung kommenden Eisenhydroxid wird eine reversible Bindung erreicht. Wenn der pH-Wert des Wassers dafür geeignete Werte annimmt oder anaerobe Zustände auftreten, kann es zu Rückbildungen von Phosphor kommen. Mit dem geschaffenen Verfahren wird diese Rückbildung verhindert. Dieses Mittel wird in Granulatform zwischen vorzugsweise schichtförmig angeordnetem Kiesmaterialien eingebracht. Vorteilhaft besteht die Zusammensetzung des chemischen Bindemittels aus einem Gewichtsanteil von 75 bis 85 % an Eisenhydroxid und einem Gewichtsanteil von 15 bis 25 % an Lanthan.

Nachfolgend soll die Erfindung anhand eines Ausführungsbeispiels näher erläutert werden. Dazu zeigen in der Zeichnung
- **Fig. 1:**: den schematischen Ablauf des Verfahrens während der Wasserzuführung,
- **Fig. 2:**: die schematische Bodenansicht des Behälters und
- **Fig. 3:**: den schematischen Ablauf des Verfahrens während der Absaugung von Wasser.

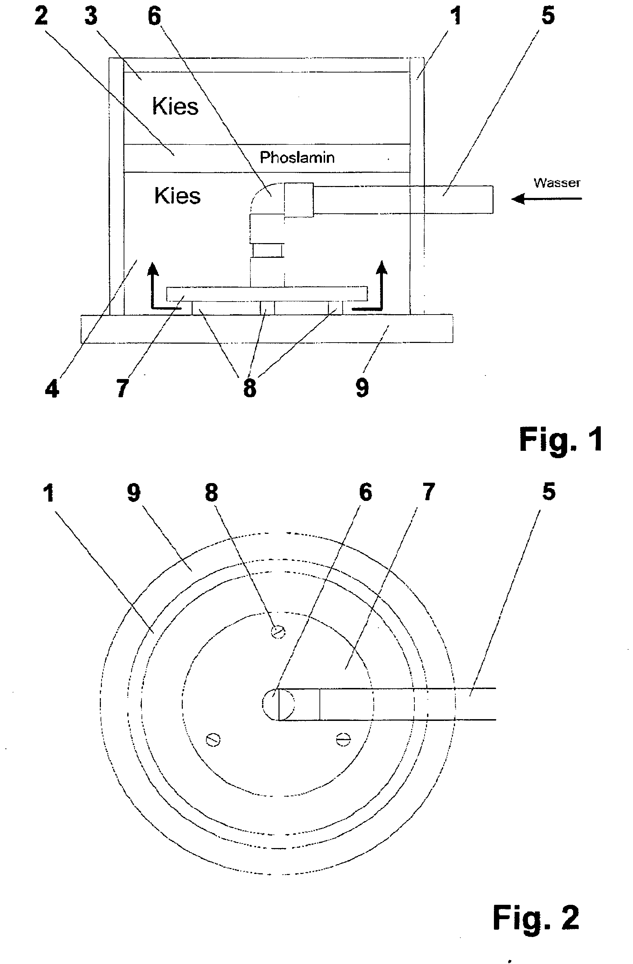

Das Ausführungsbeispiel zeigt zwei mögliche Varianten des erfindungsgemäßen Verfahrens. Eine erste Variante besteht darin, dass, wie in Fig. 1 schematisch dargestellt, eine gesteuert ablaufende chemische Bindung des gelösten Phosphors mittels einer gesteuerten Zuführung des zu behandelnden Wassers herbeizuführen. Dabei erfolgt die Steuerung der mengenmäßigen Zuführung des Wassers über eine hydraulische Druckänderung. Das zugeführte Wasser wird durch eine Wasserverteilung an die Randbereiche des Innenraumes eines Behälters geleitet. Bei der Strömung des Wassers in den oberen Bereich des Innenraumes kommt das gelöste Phosphor mit der chemischen Verbindung in Kontakt und wird dabei gebunden. Die angewendete Vorrichtung zur Durchführung des Verfahrens besteht aus einem nach oben hin geöffneten Behälter mit einem Gehäuse 1, in dem Kiesmaterialien eingebracht sind. Das Bindungsmaterial 3 ist über den gesamten Querschnitt des Innenraumes zwischen den Kiesmaterialien eingebracht und teilt dadurch diese in die Kiesschichten 2 und 4. Das aus Eisenhydroxid und Lanthan bestehende Bindemittel 3 ist granulatförmig ausgebildet und in einem netzförmigen Behälter untergebracht. Obwohl das Bindemittel 3 aus granulatförmigen einzelnen Teilen besteht, kann durch Anwendung des netzförmigen Behälters das über den gesamten Querschnitt des Innenraumes angeordnete Bindemittel 3 gesamtheitlich ausgewechselt werden. Nach der Zuführung des zu behandelnden Wassers durch das Zuleitungsrohr 5 und der Verbindungsbaugruppe 6 zur Stellplatte 7 wird das Wasser durch eine mittig in der Stellplatte 7 angeordneten Öffnung zur Bodenplatte 9 gedrückt. An der Unterseite der Stellplatte 7 sind Stellfüße 8 angebracht mit denen die Stellplatte 7 auf einer am Boden des Behälters angeordneten Bodenplatte 9 aufgestellt wird. Zwischen der Stellplatte 7 und der Bodenplatte 9 ist durch deren Anordnung zueinander ein Zwischenraum ausgebildet. Durch diesen Zwischenraum wird das Wasser aufgrund des Strömungsdruckes zu dem umfänglichen Randbereich des Innenraumes geleitet. An dem umfänglichen Randbereich strömt dann das Wasser nach oben und durchläuft nacheinander die Kiesschicht 4, das Bindemittel 2 und die Kiesschicht 3. Während der Kontaktierung des Wassers mit dem Bindemittel 2 erfolgt die Bindung des gelösten Phosphors. Je nach zugeführte Menge des Wassers pro Zeiteinheit wird der Umfang und die Geschwindigkeit des Bindungsvorganges bestimmt. In Verbindung mit einem zur Erfassung der Phosphorkonzentration dienenden Messsystem kann der Ablauf des Verfahrens objektiviert und automatisiert werden.

Die Darstellung der Figur 2 zeigt die schematische Bodenansicht des Behälters. Mit dieser Ansicht wird der kreisförmige Querschnitt des Behälters wiedergegeben. Das Gehäuse 1 des Behälters ist mit der Bodenplatte 9 verbunden. Konzentrisch innerhalb des Behälters ist die ebenfalls kreisförmig ausgebildete Stellplatte 7 angeordnet. Auf der der Bodenplatte 9 zugewandten Fläche sind Stellfüße 8 angebracht, mit denen eine beabstandete Verbindung zwischen der Bodenplatte 9 und der Stellplatte 7 hergestellt wird. Der so gebildete umfängliche Zwischenraum dient zur Strömungsführung des aus der mittig zur Stellplatte 7 eingebrachten Öffnung strömenden Wassers nach oben. Durch diese Gestaltung des Behälters wird die Strömung nahezu vollflächig auf die untere Ebene der Kiesschicht 4 geleitet und nach der Durchströmung der Kiesschicht 4 mit dem Bindemittel 2 kontaktiert. Die Verbindung zwischen dem Zuleitungsrohr 5 des zu behandelnden Wassers und der Stellplatte 7 wird über die Verbindungsbaugruppe 6 hergestellt. Durch die rechtwinklige Form der Verbindungsbaugruppe 6 wird die seitliche Anordnung des Zuleitungsrohres 5 und dadurch die seitliche Zuführung des Wassers ermöglicht.

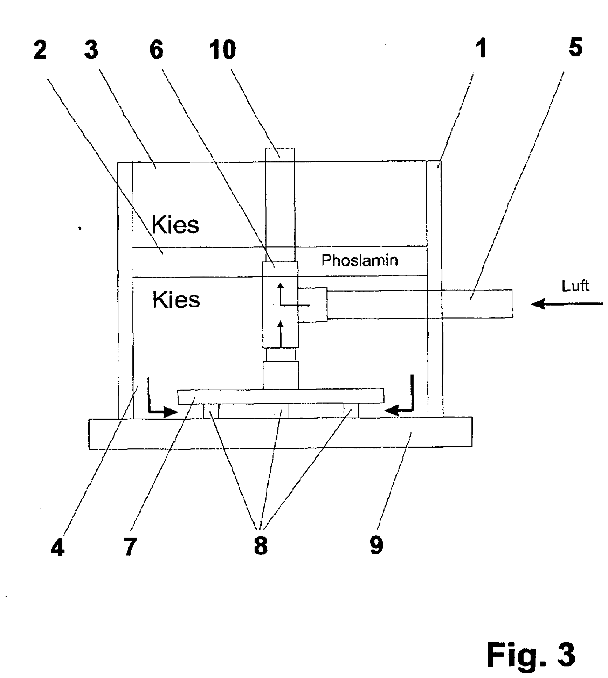

Die Darstellung der Figur 3 zeigt eine weitere Variante des erfindungsgemäßen Verfahrens mit der dazu geschaffenen Vorrichtung. Im Unterschied zur ersten Variante gemäß Figur 1 wird die Strömung des zu behandelnden Wassers durch pneumatische Absaugung erzeugt. Dazu wird durch das Zuleitungsrohr 5 Luft zugeführt und innerhalb der T-förmig ausgebildeten Verbindungsbaugruppe 6 ein Unterdruck erzeugt, der die Absaugung bewirkt. Dadurch wird das Wasser von dem umfänglichen Randbereich des Behälters zur mittig eingebrachten Öffnung der Stellplatte 7 gesaugt. Über die Verbindungsbaugruppe 6 und einem mit der Verbindungsbaugruppe 6 verbundenen Ableitungsrohr 10 wird das Wasser nach oben geleitet. Während der durch die Absaugung hervorgerufenen Strömung des zu behandelnden Wasser vom oberen Bereich des Behälters zum unteren Bereich des Behälters durchläuft das Wasser nacheinander die obere Kiesschicht 3, das Bindungsmittel 2 und die untere Kiesschicht 4. Dabei findet der chemische Bindungsvorgang des gelöstem Phosphor mit dem Bindungsmittel 2 statt.

Der wahlweise Einsatz der Vorrichtung für die vorgestellten zwei Varianten des Verfahrens wird aufgrund der geschaffenen Gestaltung der Vorrichtung auf einfache und effiziente Weise ermöglicht. Dazu ist lediglich der Austausch der Verbindungsbaugruppe 6 und für die zweite Variante noch zusätzlich das Ableitungsrohr 10 erforderlich. So ist für die erste Variante des Verfahrens nach Figur 1 eine rechtwinklige Verbindungsbaugruppe 6 und für die zweite Variante nach Figur 3 eine T-förmig ausgebildete Verbindungsbaugruppe 6 erforderlich. Die Baugruppen der Vorrichtung können dadurch baukastenartig für beide Varianten zusammengestellt werden.

Neben der Bindung von Phosphor können mit der geschaffenen Verbindung von Eisenhydroxid und Lanthan auch Silikate gebunden werden. Bei einem derartigen Einsatz werden nicht nur Grünalgen (makroskopische und mikroskopische), sondern auch Kieselalgen bekämpft.

### Bezugszeichen

- 1: Gehäuse
- 2: Mittel
- 3: Kiesschicht
- 4: Kiesschicht
- 5: Zuleitungsrohr
- 6: Verbindungsbaugruppe
- 7: Stellplatte
- 8: Stellfuß
- 9: Bodenplatte
- 10: Ableitungsrohr

## Patentansprüche

1. Verfahren zur Bindung von gelöstem Phosphor zwecks Unterstützung biologischer Filtersysteme, insbesondere innerhalb von Schwimmbädern, Teichen und Biopools, **dadurch gekennzeichnet, dass**
a) mittels gesteuerter hydraulischer Druckänderung und/oder gesteuerter pneumatischer Absaugung Strömungen des zu behandelnden Wassers erzeugt werden, die dazu führen, dass das zu behandelnde Wasser durch einen Behälter mit einem Gehäuse (1), in dem Kiesmaterialien (4, 3) eingebracht sind, fließt, und dass
b) diese Wasserströmungen durch eine Wasserverteilung (7) im Behälter über den gesamten Querschnitt des Innenraumes des Behälters (1) geführt werden, so dass Wasser durch eine Granulatform eines Bindemittels (2) fließt, und wobei das Bindemittel (2) aus chemischen Verbindungen von Eisenhydroxid und Lanthan besteht die das im Wasser gelöste Phosphor binden, und wobei das Bindemittel (2) schichtförmig über den gesamten Querschnitt des Innenraums zwischen Kiesmaterialien (4, 3) des Filtersystems angeordnet ist.

2. Verfahren nach Patentanspruch 1, **dadurch gekennzeichnet, dass** die Strömung durch hydraulischem Druck erzeugt wird.

3. Verfahren nach Patentanspruch 1, **dadurch gekennzeichnet, dass** die Strömung durch pneumatische Absaugung erzeugt wird.

4. Verfahren nach Patentanspruch 1, **dadurch gekennzeichnet, dass** die zur Bindung des gelösten Phosphors dienende chemische Verbindung einen Gewichtsanteil von 75 bis 85 % an Eisenhydroxid aufweist.

5. Verfahren nach Patentanspruch 1, **dadurch gekennzeichnet, dass** die zur Bindung des gelösten Phosphors dienende chemische Verbindung einen Gewichtsanteil von 15 bis 25 % an Lanthantrihydroxid aufweist.

6. Verfahren nach Patentanspruch 1, **dadurch gekennzeichnet, dass** die Steuerung der hydraulischen Druckänderung und/oder pneumatischen Absaugung des zu behandelnden Wassers in Abhängigkeit von einem die Phosphor-Konzentration messenden Messsystem vorgenommen wird.

## Claims

1. Method for binding dissolved phosphorus for the purpose of supporting biological filter systems, in particular within swimming pools, ponds and biopools, **characterised In that**
a) by means of controlled hydraulic pressure change and/or controlled pneumatic suction, flows are generated of the water to be treated, which result in the water to be treated flowing through a container comprising a housing (1) in which gravel materials (4, 3) are introduced, and **in that**
b) these water flows are guided through a water distribution (7) in the container over the entire cross-section of the interior of the container (1), so that water flows through a granular form of a binder (2), and wherein the binder (2) consists of chemical compounds of iron hydroxide and lanthanum, which bind the phosphorus dissolved in the water, and wherein the binder (2) is arranged in layers over the entire cross-section of the interior between gravel materials (4, 3) of the filter system.

2. Method according to claim 1, **characterised in that** the flow is generated by hydraulic pressure.

3. Method according to claim 1, **characterised in that** the flow is generated by pneumatic suction.

4. Method according to claim 1, **characterised in that** the chemical compound used for binding the dissolved phosphorus has a weight fraction of iron hydroxide of 75 to 85%.

5. Method according to claim 1, **characterised in that** the chemical compound used for binding the dissolved phosphorus has a weight fraction of lanthanum hydroxide of 15 to 25%.

6. Method according to claim 1, **characterised in that** the control of the hydraulic pressure change and/or pneumatic suction of the water to be treated is carried out dependent on a measuring system measuring the phosphorus concentration.

## Revendications

1. Procédé de liaison de phosphore dissous pour soutenir des systèmes de filtrage biologiques, en particulier à l'intérieur de piscines, de bassins et de piscines biologiques, **caractérisé en ce que**
(a) des courants de l'eau à traiter sont générés au moyen d'une variation de pression hydraulique commandée et/ou d'une aspiration pneumatique commandée, qui permettent à l'eau devant être traitée de s'écouler à travers un récipient muni d'un logement (1), dans lequel sont introduits des filtres à graviers (4, 3), et **en ce que**
(b) ces courants d'eau sont guidés à travers une répartition d'eau (7) dans le récipient sur la totalité de la section transversale de l'espace intérieur du récipient (1), de sorte que l'eau s'écoule à travers un liant (2) de forme granulaire, et le liant (2) se composant de composés chimiques à base d'hydroxyde de fer et de lanthane qui lient le phosphore dissous dans l'eau, et le liant (2) étant disposé sous forme de couches sur la totalité de la section transversale de l'espace intérieur entre les filtres à gravier (4, 3) du système de filtrage.

2. Procédé selon la revendication 1, **caractérisé en ce que** le courant est généré par la pression hydraulique.

3. Procédé selon la revendication 1, **caractérisé en ce que** le courant est généré par une aspiration pneumatique.

4. Procédé selon la revendication 1, **caractérisé en ce que** le composé chimique servant à lier le phosphore chimique présente un pourcentage en poids d'hydroxyde de fer allant de 75 à 85 %.

5. Procédé selon la revendication 1, **caractérisé en ce que** le composé chimique servant à lier le phosphore chimique présente un pourcentage en poids de trihydroxyde de lanthane allant de 15 à 25 %.

6. Procédé selon la revendication 1, **caractérisé en ce que** la commande de la variation de pression hydraulique et/ou de l'aspiration pneumatique de l'eau à traiter s'effectue en fonction d'un système de mesure mesurant la concentration en phosphore.
